**Europäisches Patentamt**

**European Patent Office**

**Office européen des brevets**

(11) Publication number: **0 025 347**
**B1**

(12) **EUROPEAN PATENT SPECIFICATION**

(45) Date of publication of patent specification: **29.04.87**

(51) Int. Cl.⁴: **G 11 C 17/00, H 01 L 23/52**

(21) Application number: **80303113.7**

(22) Date of filing: **04.09.80**

(54) **Semiconductor devices having fuses.**

(30) Priority: **05.09.79 JP 122908/79**

(43) Date of publication of application:
**18.03.81 Bulletin 81/11**

(45) Publication of the grant of the patent:
**29.04.87 Bulletin 87/18**

(84) Designated Contracting States:
**DE FR GB NL**

(56) References cited:
**US-A-3 792 319**
**US-A-4 045 310**

**IBM TECHNICAL DISCLOSURE BULLETIN, vol. 19, no. 4, September 1976, page 1161, New York, US, B.J. DELIDUKA et al.: "Monolithic integrated circuit fuse link"**

(73) Proprietor: **FUJITSU LIMITED**
**1015, Kamikodanaka Nakahara-ku**
**Kawasaki-shi Kanagawa 211 (JP)**

(72) Inventor: **Mochizuki, Hirohiko**
**43-10-908, Toyama-cho**
**Shinjyuku-ku, Tokyo 162 (JP)**
Inventor: **Nakano, Masao**
**473-4, Hisasue**
**Takatsu-ku, Kawasaki-shi Kanagawa 211 (JP)**
Inventor: **Baba, Fumio**
**3-12-204, Sakonyama**
**Asahi-ku Yokohama-shi, Kanagawa 241 (JP)**
Inventor: **Nakano, Tomio**
**1-11-2-12-404, Shirahatadai**
**Takatsu-ku, Kawasaki-shi, Kanagawa 211 (JP)**
Inventor: **Takemae, Yoshihiro**
**20-5-9-301, Utsukushigaoka 1-chome**
**Midori-ku, Yokohama-shi Kanagawa 227 (JP)**

(74) Representative: **Abbott, Leonard Charles et al**
**GILL JENNINGS & EVERY 53-64 Chancery Lane**
**London WC2A 1HN (GB)**

## Description

The present invention relates to semiconductor devices having fuses and, more particularly, to memory devices having spare (i.e. redundant) memory cells, and fuse-link programmable read-only memory (PROM) devices.

A semiconductor memory is organized as a matrix of horizontal or row lines and vertical or column lines. At each intersection of the matrix a memory cell is provided which is able to store one bit of information. If at least one defect, e.g. a defective memory cell, occurs in a memory devices, the devices should be abandoned. However, if the number of the defects is small, the bad memory device can be changed into a good memory device by using a redundancy technique. It is possible to remarkably increase the production yield by providing redundant (i.e. spare) row and column lines in the memory device. The spare row lines and spare column lines which form spare memory cells are built into the memory device while it is being produced. When, for example, a row line of a defective memory cell (i.e. a defective bit) is found during testing, the defective row line is eliminated and a spare row line is substituted in its place. Namely, the defective row line is cut off from the regular row decoder thereof and, simultaneously, the spare row decoder of the spare row line is formed to respond to the same address as that of the defective row line to be replaced. Thus, the spare row decoder behaves exactly like the regular row decoder. The above-mentioned cutting off of the defective row line and formation of the spare row decoder can be carried out by blowing fuses provided between the regular row recoder and the row line and within the spare row recoder. Similarly, a defective column line can be eliminated and a spare column line can be substituted in its place. Generally, fuses are formed in every row line, every column line, every spare row decoder and every spare column decoder of a semiconductor memory device.

There is a well-known fuse-link-programmable read-only memory (PROM) device provided with fuses in every bit (i.e. memory cell). In order to write information, a fuse in a bit is blown by passing excess current (i.e. fusing current) between a row line and a column line of the bit.

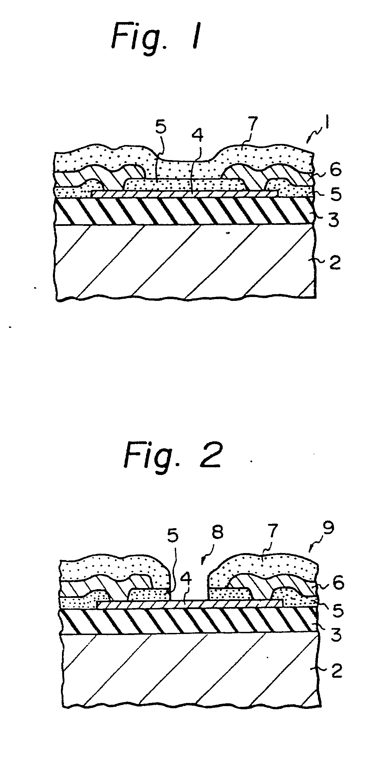

A fuse element comprising the above-mentioned fuses of the semiconductor memory device having redundant memory cells and of the fuse-link PROM has a structure as illustrated in Fig. 1. The fuse element 1 of Fig. 1 is produced in the following manner. The starting material is a semiconductor substrate (e.g. silicon wafer) 2. An isolating layer (e.g. silicon dioxide layer) 3 is formed on the semiconductor substrate 2 by chemical vapor deposition or thermal oxidation of silicon. Fuse material, e.g. poly-silicon, nichrome (Ni-Cr), titanium-tungsten (Ti-W) or platinum silicide (PtSi), is deposited on the isolating layer 3 by vapor deposition or sputtering and, then, is patterned by photoetching to form a fuse 4 having a so-called bow-tie shape which consists of two relatively large rectangular portions and a belt shaped portion connecting the two rectangular portions. An insulating layer 5 of silicon dioxide ($SiO_2$), silicon nitride ($SiN_4$) or phospho-silicate glass (PSG) is formed on the fuse 4 and the isolating layer 3 by chemical vapor deposition and, then, is selectively etched to open two windows for electrical contact on the fuse 4 by photoetching. Then, a conductor material (e.g. aluminium) is formed by vapor deposition and is selectively etched to form predetermined conductor lines 6 by photoetching. A protecting layer 7 of silicon dioxide, silicon nitride or phospho-silicate glass is formed on the conductor lines 6 and the insulating layer 5.

Fusing of the fuse 4 is performed by passing a fusing current through the fuse 4 via the conductor lines 6. The fusing current is limited to a value of current which is allowed to pass through a metal oxide semiconductor (MOS) transistor or a bipolar transistor in a memory device. However, it is possible that a fuse cannot be blown by passing a predetermined fusing current and/or that a small bridge is formed between separated portions of the blown fuse, and therefore, fuse reliability is low.

In US—A—3792319, an insulating layer is deposited on a substrate and fusible links with narrowed central portions are formed on the insulating layer. A passivation layer is then deposited, leaving windows for connecting to the ends of the fusible links, after which conductive material is laid down to connect to the fusible links through the windows. It is also proposed to provide further openings over the narrow central portions of the fusible links to expose these links to an oxygen environment to facilitate fusing.

US—A—4045310 is also concerned with making a ROM by the fusing of fusible links in a semiconductor device. In this disclosure, apertures are opened in a passivation layer above a conductive layer to enable the conductive layer to be thinned by etching to form the fusible link. The passivation material is then redeposited in the apertures, after which the fusing operation is carried out.

The present invention consists in a process for making a semiconductor device comprising the steps of:

(a) forming an isolating layer on a semiconductor substrate;

(b) forming fuse material on the isolating layer in a bow-tie shape;

(c) forming an insulating layer over the fuse material and the isolating layer, shaped to provide windows giving access to end portions of the fuse material for electrical contact;

(d) depositing conductor material in a predetermined shape over the insulating layer and through the windows to the fusing material;

(e) forming a protective layer over the conductor material and the insulating layer;

(f) forming another window in the protective layer and the insulating layer to expose a narrow centre portion of the fuse material;

(g) applying sufficient electrical current through the conductor material to the end portions of the fuse material to open a gap in the narrow middle portion of the fuse material; and

(h) forming an additional protective layer so as to fill the said other window after the step (g).

The invention further consists in a semiconductor memory device having fuses, some of which have been blown, and having the protective layer covering at least the locations of the central portions of the fuses made by the above method.

In order that the invention may be better understood, an embodiment of the invention will now be described with reference to the accompanying drawings, in which:

Figure 1 is a schematic, cross-sectional view of a conventional fuse element of a semiconductor device;

Figure 2 is a schematic, cross-sectional view of an improved fuse element after the window-forming stage;

Figure 3 is a plan view of the improved fuse element of Figure 2; and

Figure 4 is a schematic, cross-sectional view of the improved fuse element with the additional protecting layer, according to the present invention.

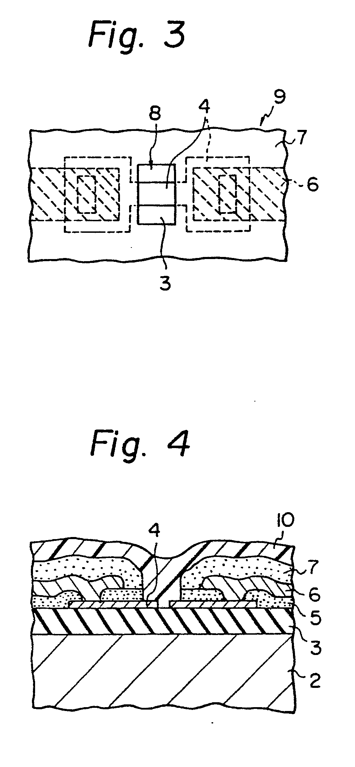

Referring to Figures 2, 3 and 4, there is illustrated a fuse element 9 improved in accordance with the present invention. Reference numerals 2 through 7 in Figures 2 and 3 represent the same parts as those represented by the reference numerals 2 through 7 in Figure 1. After formation of the protecting layer 7 a window 8 is opened by photoetching to expose a narrow centre portion of the fuse 4 as illustrated in Figures 2 and 3. The fuse 4 has a bow-tie shape as illustrated in Figure 3, so that the narrow centre portion exposed within the window 8 of the fuse 4 can be easily and surely blown by passing a fusing current through the fuse 4. A gap between separated portions of the fuse 4 generated by fusing is wider than that between separated portions of a fuse which is completely coated with a protecting layer being generated by fusing. The narrow centre portion of each blown and unblown fuse in a semiconductor device is exposed within windows formed in the protecting layer.

Example

Bow-tie shaped fuses of polysilicon were formed by chemical vapor deposition on a silicon dioxide ($SiO_2$) layer which was formed by thermally oxidizing a silicon single crystalline substrate. Each of the fuses had a thickness of 0.3 microns. A narrow centre portion of the fuse had a width of 2.5 microns and a length of 7 microns. After formation of a protecting layer of phosphosilicate glass on the fuses, rectangular windows of 5 microns by 10 microns were formed in the protecting layer on the narrow centre portions of the fuses by photoetching. The fuses were blown by passing a fusing current through the fuses. The peak value of the fusing current was in the range of from 50 to 60 milliamperes. As a comparative example the above-mentioned poly-silicon fuses were blown by passing a fusing current prior to the opening of the windows. In this case the peak value of the fusing current was in the range of from 70 to 80 milliamperes. Furthermore, fused gaps between separated portions of the fuses with windows were wider than those of separated portions of the fuses without windows.

According to the present invention, an additional protecting layer 10, preferably of phosphosilicate glass, silicon nitride or polyimide, is formed subsequent to the fusing operation, so as to plug up the window 8, as illustrated in Figure 4. Thus, the blown fuses and unblown fuses in the semiconductor device are coated with the additional protecting layer 10.

**Claims**

1. A process for making a semiconductor device comprising the steps of:

(a) forming an isolating layer (3) on a semiconductor substrate (2);

(b) forming fuse material (4) on the isolating layer (3) in a bow-tie shape;

(c) forming an insulating layer (5) over the fuse material (4) and the isolating layer (3), shaped to provide windows giving access to end portions of the fuse material (4) for electrical contact;

(d) depositing conductor material (6) in a predetermined shape over the insulating layer (5) and through the windows to the fuse material;

(e) forming a protective layer (7) over the conductor material (6) and the insulating layer (5);

(f) forming another window (8) in the protective layer (7) and the insulating layer (5) to expose a narrow centre portion of the fuse material (4);

(g) applying sufficient electrical current through the conductor material (6) to the end portions of the fuse material (4) to open a gap in the narrow centre portion of the fuse material; and

(h) forming an additional protective layer (10) so as to fill the said other window (8) after the step (g).

2. A process in accordance with claim 1, characterized in that the material of the additional protecting layer (10) is selected from the group consisting of silicon nitride, phosphosilicate glass and polyimide.

3. A process in accordance with claim 1, wherein the additional protective layer (10) covers the fuse material (4), the isolating layer (3) and the protective layer (7).

4. A process in accordance with claim 1, wherein the protective layer (7) is made of material selected from the group consisting essentially of silicon dioxide, silicon nitride and phosphosilicate glass.

5. A semiconductor device having fuses, some of which have been blown, and having an isolating layer (3) on a semiconductor substrate (2); fuse material (4) on the isolating layer (3), constituting the said fuses; an insulating layer (5) lying over the fuse material (4) and the isolating layer (3), and shaped to provide windows giving access to end portions of the fuse material (4); conductor-material (6) extending in a predetermined shape over the insulating layer (5) and passing through the windows to the fuse material; a protective layer (7) over the conductor material (6) and the insulating layer (5), the protective layer (7) and the insulating layer (5) being formed with another window (8) for each fuse, registering with a narrow centre portion of the fuse; and an additional protective layer (10) filling the said other window (8), the device being made by the process of any one of claims 1 to 4.

### Patentansprüche

1. Verfahren zur Herstellung einer Halbleitervorrichtung mit folgenden Schritten:

(a) Bildung einer isolierenden Schicht (3) auf einem Halbleitersubstrat (2);

(b) Bildung von Schmelzmaterial (4) in Form einer Fliege auf der isolierenden Schicht (3);

(c) Bildung einer isolierenden Schicht (5) über dem Schmelzmaterial (4) und der isolierenden Schicht (3), so geformt, daß Fenster vorgesehen sind, die Zugang zu den Endabschnitten des Schmelzmaterials (4) für einen elektrischen Kontakt ermöglichen;

(d) Niederschlagen von Leitermaterial (6) in einer vorbestimmten Form über der isolierenden Schicht (5) und durch die Fenster des Schmelzmaterials;

(e) Bildung einer Schutzschicht (7) über dem Leitermaterial (6) und der isolierenden Schicht (5);

(f) Bildung eines anderen Fensters (8) in der Schutzschicht (7) und der isolierenden Schicht (5), um einen schmalen zentralen Abschnitt des Schmelzmaterials (4) zu exponieren;

(g) Aufbringen eines hinreichenden elektrischen Stromes durch das Leitermaterial zu den Endabschnitten des Schmelzmaterials (4), um einen Spalt in dem schmalen zentralen Abschnitt des Schmelzmaterials zu öffnen; und

(h) Bildung einer zusätzlichen Schutzschicht (10), um so das genannte andere Fenster (8) nach dem Schritt (g) zu füllen.

2. Verfahren nach Anspruch 1, dadurch gekennzeichnet, daß das Material der zusätzlichen Schutzschicht (10) ausgewählt ist aus der Gruppe bestehend aus Siliziumnitrid, Phosphosilikatglas und Polyimid.

3. Verfahren nach Anspruch 1, bei dem die zusätzliche Schutzschicht (10) das Schmelzmaterial (4), die isolierende Schicht (3) und die Schutzschicht (7) bedeckt.

4. Verfahren nach Anspruch 1, bei dem die Schutzschicht (7) aus einem Material hergestellt ist, das ausgewählt ist aus der Gruppe bestehend im wesentlichen aus Siliziumdioxid, Siliziumnitrid und Phosphosilikatglas.

5. Halbleitervorrichtung mit Schmelzsicherungen, von denen einige durchgeschmolzen sind, und mit einer isolierenden Schicht (3) auf einem Halbleitersubstrat (2); Schmelzmaterial (4), welches die genannten Schmelzsicherungen bildet, auf der isolierenden Schicht (3); einer isolierende Schicht (5), die über dem Schmelzmaterial (4) und der isolierenden Schicht (3) liegt und geformt ist, um Fenster zu bilden, die Zugriff zu den Endabschnitten des Schmelzmaterials (4) freigeben; Leitermaterial (6), das sich in einer vorbestimmten Form über der isolierenden Schicht (5) erstreckt und durch die Fenster zu dem Schmelzmaterial durchdringt; einer Schutzschicht (7) über dem Leitermaterial (6) und der isolierenden Schicht (5), wobei die Schutzschicht (7) und die isolierende Schicht (5) mit einem anderen Fenster (8) für jede Schmelzsicherung ausgebildet sind, ausgerichtet mit einem schmalen zentralen Abschnitt der Schmelzsicherung; und einer zusätzlichen Schutzschicht (10), die das andere Fenster (8) füllt, wobei die Vorrichtung durch ein Verfahren nach einem der Ansprüche 1 bis 4 hergestellt ist.

### Revendications

1. Procédé de fabrication d'un dispositif semiconducteur, comprenant les opérations suivantes:

(a) former une couche isolante (3) sur un substrat semi-conducteur (2);

(b) former un matériau de fusible (4) sur la couche isolante (3) suivant une forme de noeud papillon;

(c) former une couche isolante (5) au-dessus du matériau de fusible (4) et de la couche isolante (3), conformée de manière à présenter des fenêtres donnant accès à des parties terminales du matériau de fusible (4) pour assurer le contact électrique;

(d) déposer un matériau conducteur (6) suivant une forme prédéterminée au-dessus de la couche isolante (5) et dans les fenêtres jusqu'au matériau de fusible;

(e) former une couche protectrice (7) au-dessus du matériau conducteur (6) et de la couche isolante (5);

(f) former une autre fenêtre (8) dans la couche protectrice (7) et la couche isolante (5) afin d'exposer une partie centrale étroite du matériau de fusible (4);

(g) appliquer une intensité de courant électrique suffisante au travers du matériau conducteur (6) jusqu'aux parties terminales du matériau de fusible (4) afin d'ouvrir un intervalle dans la partie centrale étroite du matériau de fusible; et

(h) former une couche protectrice supplémentaire (10) de manière à remplir ladite autre fenêtre (8) après l'opération (g).

2. Procédé selon la revendication 1, caractérisé en ce que le matériau de la couche protectrice supplémentaire (10) est choisi dans le groupe constitué du nitrure de silicium, du verre au phosphosilicate et du polyimide.

3. Procédé selon la revendication 1, où la couche protectrice supplémentaire (10) couvre le matériau de fusible (4), la couche isolante (3) et la couche protectrice (7).

4. Procédé selon la revendication 1, où la couche protectrice (7) est fait en un matériau choisi dans le groupe comprenant essentiellement le dioxyde de silicium, le nitrure de silicium et le verre au phosphosilicate.

5. Dispositif semi-conducteur possédant des fusibles, dont certains sont fondus, et possédant une couche isolante (3) sur un substrat semi-conducteur (2); un matériau de fusible (4) sur la couche isolante (3) constituant lesdits fusibles; une couche isolante (5) s'étendant au-dessus du matériau de fusible (4) et de la couche isolante (3), et conformée de manière à offrir des fenêtres donnant accès à des parties terminales du matériau de fusible (4); un matériau conducteur (6) s'étendant suivant une forme prédéterminée au-dessus de la couche isolante (5) et passant dans les fenêtres pour atteindre le matériau de fusible; une couche protectrice (7) s'étendant au-dessus du matériau conducteur (6) et de la couche isolante (5), la couche protectrice (7) et la couche isolante (5) étant dotées d'une autre fenêtre (8) pour chaque fusible, en concordance avec une partie centrale étroite du fusible; et une couche protectrice supplémentaire (10) remplissant ladite autre fenêtre (8), le dispositif étant fait à l'aide du procédé selon l'une des revendications 1 à 4.

# Fig. 1

# Fig. 2

# Fig. 3

# Fig. 4